(19) Europäisches Patentamt
European Patent Office
Office européen des brevets

(11) Veröffentlichungsnummer: **0 002 805**
**B1**

(12) **EUROPÄISCHE PATENTSCHRIFT**

(45) Veröffentlichungstag der Patentschrift: **07.01.81**

(51) Int. Cl.³: **C 08 F 2/50,** G 03 C 1/68

(21) Anmeldenummer: **78101799.1**

(22) Anmeldetag: **21.12.78**

(54) **Photopolymerisierbare Überzugs- und Aufzeichnungsmaterialien, wie Photolackübertragungsfolien und Photoresistmaterialien, enthaltend einen Photoinitiator und eine organische Halogenverbindung.**

(30) Priorität: **31.12.77 DE 2759164**

(43) Veröffentlichungstag der Anmeldung: **11.07.79 Patentblatt 79/14**

(45) Bekanntmachung des Hinweises auf die Patenterteilung: **07.01.81 Patentblatt 81/1**

(84) Benannte Vertragsstaaten: **CH DE FR GB SE**

(56) Entgegenhaltungen:
**DE-A-1 949 010**
**FR-A-2 216 304**

(73) Patentinhaber: ***BASF Aktiengesellschaft,***
**Carl-Bosch-Strasse 38, D-6700 Ludwigshafen (DE)**

(72) Erfinder: **Barzynski, Helmut, Dr., An der Ameisenhalde 49, D-6702 Bad Duerkheim 1 (DE)**
Erfinder: **Saenger, Dietrich, Dr., Lorcher Ring 16 a, D-6710 Frankenthal (DE)**

**EP 0 002 805 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchgebühr entrichtet worden ist (Art. 99(1) Europäisches Patentübereinkommen).

# Photopolymerisierbare Überzugs- und Aufzeichnungsmaterialien, wie Photolackübertragungsfolien und Photoresistmaterialien, enthaltend einen Photoinitiator und eine organische Halogenverbindung

Die Erfindung betrifft photopolymerisierbare Überzugs- und Aufzeichnungsmaterialien mit mindestens einer photopolymerisierbaren olefinisch ungesättigten organischen Verbindung, die zur Erzielung verbesserter Härteeigenschaften bei Bestrahlung mit aktinischem Licht neben einem Photoinitiator bestimmte organische Halogenverbindungen enthalten. Sie sind insbesondere geeignet als Materialien für die Herstellung von Druckplatten, Photolackübertragungsfolien und photopolymeren silberfreien photographischen Filmen.

Photopolymerisierbare Überzugs- und Aufzeichnungsmaterialien für die genannten Anwendungszwecke sind an sich bekannt, und es wurde bereits eine Reihe von Kombinationen von chemischen Verbindungen für deren verbesserte Härtung durch UV-Bestrahlung in der Literatur beschrieben. Bei den bekannten, bei Raumtemperatur festen Überzugs- und Aufzeichnungsmaterialien ist ein häufig auftretender Nachteil, dass die Geschwindigkeit der durch Bestrahlung mit aktinischem Licht induzierten Polymerisation besonders bei hoher Zähigkeit bzw. Viskosität der Masse gegen Reaktionsende stark abnimmt und eine praktisch vollständige Polymerisation oder Vernetzung der vorhandenen olefinisch ungesättigten Bindungen bei üblichen Belichtungszeiten nicht erreicht wird. Es müssen daher solche Überzugs- und Aufzeichnungsmaterialien in der Praxis zu lange belichtet werden, besonders wenn man nach einer bildmässigen Belichtung die unbelichteten Anteile mit einem Lösungsmittel auswaschen will oder wenn mit dem Ausmass der Photopolymerisation die Oberflächenklebrigkeit oder die Haftwerte zu einem flächigen Substrat sich ändern.

Aus der DE-OS 1949010 und den US-PS 4040923 sowie 4043887 ist bekannt, als Photoinitiator für photopolymerisierbare Verbindungen Benzophenonderivate zu verwenden, die chlorierte oder bromierte Methylgruppe an den aromatischen Ringen aufweisen wie 4-Chlormethylbenzophenon, 3,4- oder 4,4′ -Bis (chlormethyl)-benzophenon oder 4,4′ -Bis(brommethyl)benzophenon. Die Lichtempfindlichkeit dieser Systeme ist jedoch noch unbefriedigend. Ferner ist nachteilig, dass ein Verhältnis von Photoinitiator zu Aktivator nicht variierbar ist. Aus der DE-OS 2404156, die der FR-PS 2216304 und den US-PS 3933682 und 3966573 entspricht, sowie der BE-PS 853935 ist bekannt, als Photoinitiatorsystem eine Kombination von a) Acyloinen oder aromatischen Ketonen mit b) einer N, P, As, Bi oder Sb enthaltenden Verbindung wie einem Amin, Phosphin oder Arsin sowie c) einem halogenierten aliphatischen, alicyclischen oder aromatischen Kohlenwasserstoff zu verwenden. Jedoch ist die Lagerstabilität von Aufzeichnungsmaterialien mit diesen Systemen in vielen Fällen unbefriedigend. Bei Verwendung von Verbindungen b), die basisch sind wie von Aminen, ist es zudem manchmal nicht möglich, durch eine Farbänderung eines üblichen zugesetzten Farbstoffindikators allgemeiner Natur zwischen belichteten und unbelichteten Bildteilen unterscheiden zu können.

Der vorliegenden Erfindung lag die Aufgabe zugrunde, für insbesondere bei Raumtemperatur feste photopolymerisierbare Überzugs- und Aufzeichnungsmaterialien mit photopolymerisierbaren olefinisch ungesättigten organischen Verbindungen ein Photoinitiator-Aktivator-System zu finden, das eine verbesserte Durchhärtung bei normalen Belichtungszeiten gestattet, das ein unkritischeres Arbeiten bezüglich der zulässigen Auswaschzeiten beim Auswaschen von unbelichteten Anteilen mit Lösungsmitteln auch nach Anwendung normaler Belichtungszeiten erlaubt bzw. die Nachteile der genannten bekannten Systeme in zumindest geringerem Umfang oder nicht zeigt.

Es wurde gefunden, dass photopolymerisierbare Überzugs- und Aufzeichnungsmaterialien mit mindestens einer photopolymerisierbaren olefinisch ungesättigten organischen Verbindung, die als aktiviertes Photoinitiator-System

a) mindestens eine bei Belichtung mit aktinischem Licht polymerisationsauslösende Radikale bildende aromatische Carbonylverbindung und

b) einen halogenierten Kohlenwasserstoff

enthalten, die gewünschten Verbesserungen zeigen, wenn sie als halogenierten Kohlenwasserstoff b) eine mindestens zwei an den Benzolkern gebundene Dichlormethylgruppen aufweidende Benzolverbindung aufweisen.

Bevorzugt enthalten die erfindungsgemässen Überzugs- und Aufzeichnungsmaterialien zusätzlich einen Indikatorfarbstoff, der bei Säurezugabe seine Farbe ändert.

Als erfindungsgemäss im aktivierten Photoinitiator-System enthaltene mindestens zwei an den Benzolkern gebundene Dichlormethylgruppen ($-CHCl_2$) aufweisende Benzolverbindungen kommen Benzolverbindungen der Formel

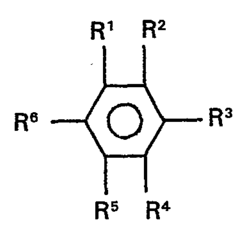

in Frage mit gleichen oder unterschiedlichen Substituenten $R^1$ bis $R^6$, von denen mindestens 2 Substituenten den Rest $-CHCl_2$ darstellen, die restlichen Reste können gleich oder verschieden beliebig gewählt werden, vorausgesetzt, dass sie sich gegenüber den Dichlormethylgruppen inert verhalten und die Photopolymerisation nicht stören und keine starke Absorption im Bereich von aktinischem Licht aufweisen, d.h. der dekadische Extinktions-Koeffizient sollte bevorzugt im Be-

reich von $\lambda$ = 315–400 nm kleiner als 20 [Liter·Mol$^{-1}$·cm$^{-1}$] sein. Bevorzugt stellen die restlichen Reste Wasserstoff, Halogen, vor allem Chlor, $C_1$- bis $C_{10}$-Kohlenwasserstoffreste, halogenierte $C_1$ bis $C_{10}$-Alkylreste oder gegebenenfalls halogenierte $C_1$- bis $C_{10}$-Alkoxyreste dar. Als sehr geeignete Dichlormethylgruppen aufweisende Benzolverbindungen seien Bis(dichlormethyl)-benzole wie 1,4-Bis(dichlormethyl)-benzol sowie 2,5-Dichlor-1,4-bis(dichlormethyl)-benzol genannt.

Die zugesetzte Menge an der Dichlormethylbenzolverbindung beträgt im allgemeinen 0,2 bis 12 Gewichtsteile des Aktivators b) pro Gewichtsteil an Photoinitiator a), wobei die Aktivatorkonzentration jedoch mindestens 0,5 Gew.% der Gesamtmasse betragen sollte.

Als mindestens eine der Belichtung mit aktinischem Licht polymerisationsauslösende Radikale bildende aromatische Carbonylverbindungen a) kommen die als Photoinitiatoren bekannten aromatischen Carbonylverbindungen wie aromatische Aldehyde und aromatische Ketone in Frage. Verwiesen sei besonders auf die in der bereits genannten US-PS 3933682 in Spalte 1, Zeile 35 bis Spalte 2, Zeile 19 sowie die in Kosar, Light Sensitive Systems, J. Wiley, New York 1965, Seiten 158 bis 193, angeführten entsprechenden Verbindungen, die auch im Gemisch miteinander oder in Kombination mit weiteren Photoinitiatoren angewandt werden können. Besonders hervorgehoben seien gegebenenfalls substituierte Benzophenone wie Benzophenon und Michlers Keton, Benzoinäther, wie Benzoin-isopropyläther, Äther von in $\alpha$-Stellung mit einem $C_1$- bis $C_8$-Hydroxyalkyl, $C_2$- bis $C_8$-Alkoxyalkyl- oder $C_1$- bis $C_7$-Kohlenwasserstoffrest substituierten Benzoinen, wie $\alpha$-Hydroxymethylbenzoinmethyläther, Benzilketale, wie Benzildimethylketal, Anthrachinon und seine Derivate, Thioxanthon und seine Derivate, sowie die Kobinationen von Benzophenonderivaten wie von Benzophenon mit Michlers Keton. Die spezielle Eignung bestimmter Photoinitiator(kombination)en lässt sich nach Kenntnis der erfinderischen Lehre mit wenigen Handversuchen rasch feststellen.

Als Materialien mit mindestens einer photopholymerisierbaren olefinisch ungesättigten organischen Verbindung kommen die an sich bekannten photopolymerisierbaren Massen, die für die Herstellung von Überzügen, Druckplatten, Photoresistmaterialien, Photolacküberträgungsfolien, photopolymeren silberfreien photophotolymerischen Filmen und ähnliche Zwecke beschrieben sind, in Frage. Sie enthalten olefinisch ungesättigte organische Verbindungen in Form von olefinisch ungesättigten Monomeren, Präpolymeren oder Polymeren mit olefinisch ungesättigten C-C-Doppelbindungen. Die olefinisch ungesättigten Verbindungen sollen mindestens eine endständige $CH_2$=C-Gruppe enthalten, einen Siedpunkt von über 100°C bei Atmosphärendruck aufweisen und zur Bildung von Polymeren durch photoinitierte Polymerisationsreaktion fähig sein. Geeignete Massen sind z.B. in den US-PS 2760863, 3966573, DE-AS 1622297, DE-OS 1522444, DE-OS 2215090 oder BE-PS 560154, beschrieben. Die erfindungsgemässe Lehre ist dabei von besonderem Vorteil für photopolymerisierbare Massen, die bereits vor der Härtung (Belichtung) bei Raumtemperatur fest sind oder nach etwa 50%iger Umsetzung der photopolymerisierbaren olefinisch ungestättigten C-C-Doppelbindungen eine bei Raumtemperatur feste Masse bilden, für Massen also, die in der letzten Phase der Härtung eine hohe Zähigkeit bzw. Viskosität aufweisen und somit dann eine niedere Beweglichkeit für die Reaktanten bieten.

Die bevorzugten Massen enthalten neben photopolymerisierbaren Monomeren polymere Produkte als Bindemittelkomponente. Sie organischen polymeren Bindemittel sollen dabei mit den mitverwendeten Monomeren im allgemeinen verträglich und – für den Fachmann selbstverständlich – in den Entwicklerlösungsmitteln löslich oder dispergierbar sein, um ein Auswaschen der unbelichteten und unvernetzten Anteile einer Schicht oder photopolymerisierbaren Massen im Falle einer bildmässigen Belichtung zu ermöglichen. Als geeignete polymere olefinisch gesättigte oder ungesättigte Bindemittel seien genannt lineare Polyamide und besonders alkohol-lösliche Copolyamide, wie sie in der FR-PS 1520856 beschrieben sind, Cellulosederivate, insbesondere wässrig-alkalisch auswaschbare Cellulosederivate, Vinylalkohol-Polymere und Polymere und Copolymere von Vinylestern aliphatischer Monocarbonsäuren mit 1 bis 4 C-Atomen, wie von Vinylacetat, mit unterschiedlichem Verseifungsgrad, Homo- und Copolymerisate des Vinylpyrrolidons, des Vinylchlorids oder des Styrols, Polyurethane, Polyätherurethane, Polyesterurethane, Polyesterharze, Acryl- sowie Methacrylsäure-ester-Copolymere wie Copolymere des Methylmethacrylats mit Acrylsäure, Methacrylsäure, Acrylamid und/oder Hydroxalkyl(meth)acrylaten, und elastomere Dien-Polymere und -Copolymere wie Blockcopolymere aus Butadien- und/oder Isopren-Homopolymerblöcken und Polymerblöcken aus Styrol oder $\alpha$-Methylstyrol.

Von den niedermolekularen Verbindungen mit mindestens einer photopolymerisierbaren olefinisch ungesättigten Doppelbindung sind bevorzugt Monomere mit zwei oder mehr olefinisch ungesättigten photopholymerisierbaren Doppelbindungen allein oder deren Mischung mit Monomeren mit nur einer olefinisch ungesättigten photopolymerisierbaren Doppelbindung. Die Art der verwendeten Monomeren richtet sich weitgehend nach dem Anwendungszweck und nach der Art des mitverwendeten polymeren Bindemittels. So sind bei Mischungen mit ungesättigten Polyesterharzen besonders zwei oder mehr Doppelbindungen enthaltende Allylverbindungen, wie Maleinsäuredialkylester, Allylacrylat, Diallylphthalat, Trimellithsäuredi- und -triallylester oder Äthylenglykolbisallylcarbonat, sowie Di- und Polyacrylate und -methacrylate geeignet, wie sie durch Veresterung von Diolen oder Polyolen mit Acrylsäure oder Methacrylsäure hergestellt werden können, wie die Di- und Tri(meth)-acrylate von Äthylenglykol, Diäthylenglykol, Triäthylenglykol, Polyäthylenglykol mit einem Molekulargewicht bis etwa 500, 1,2-Propandiol, 1,3-Propandiol, Neopentylglykol (2,2-Dimethylpropandiol), 1,4-Butandiol, 1,1,1-Trimethylolpropan, Glycerin oder Pentaerythrit; ferner die Monoacrylate und Monomethacrylate solcher Diole und Polyole, wie z.B. Äthylenglykol- oder Di-, Tri- oder Tetraäthylengloykol-monoacrylat, Monomere mit zwei oder mehr olefinisch ungesättigten Bindungen, die Urethangruppen und/oder Amidgruppen enthalten, wie die aus aliphatischen Diolen der vorstehend genannten Art, organischen Diisocyanaten und Hydroxyalkyl(meth)acrylaten hergestellten niedermolekularen Verbindungen. Genannt seien auch Acrylsäure, Methacrylsäure sowie deren Derivate wie (Meth)acrylamid, N-Hydroxymethyl(meth)acrylamid oder (Meth)acrylate von Monoalkoholen mit 1 bis 6 C-Atomen. Mischungen von Allylmonomeren mit Di- oder Polyacrylaten sind sehr geeignet. Wählt man Mischungen mit Polyamiden als polymere Bindemittel, so eignen sich von den genannten Monomerarten neben den Di- und Polyacrylaten besonders solche, die zusätzlich zu den Doppelbindungen noch Amid- und/oder Urethangruppen enthalten wie Derivate von Acrylamiden, z.B. die Umsetzungsprodukte von 2 Mol N-Hydroxymethyl(meth)-acrylamid mit 1 Mol eines aliphatischen Diols, wie Äthylenglykol, Xylylen-bis-acrylamid oder Alkylen-bis-acrylamide mit 1 bis 8 C-Atomen im Alkylenrest. Für die Herstellung wässrig-alkalisch entwickelbarer Druckplatten mit Polyvinylalkohol als polymerem Bindemittel eignen sich besonders wasserlösliche Monomere, wie z.B. Hydroxyäthyl(meth)acrylat und Mono- und Di(meth)acrylate von Polyäthylenglykolen mit einem Molekulargewicht von etwa 200 bis 500. Für die Herstellung von Photolacküberträgungsfolien (Photoresist-Herstellung) mit Copolymeren von Acrylaten oder Methacrylaten wie Methylmethacrylat-Copolymerisaten als polymere Bindemittel eignen sich besonders Di- und Polyacrylate und -methacrylate, wie sie vorstehend im Zusammenhang mit Polyesterharzen aufgeführt sind.

Das Mengenverhältnis in der Mischung von Monomeren und polymerem Bindemittel ist in weitem Umfang variierbar, es beträgt im allgemeinen 10 bis 55 und insbesondere 25 bis 50 Gew.% an Monomeren und 45 bis 90 und insbesondere 50 bis 75 Gew.% an polymerem Bindemittel, bezogen auf die Summe der Mengen von Monomeren und polymeren Bindemitteln.

Die Menge an zugesetztem aktiviertem Photoinitiatorsystem aus Photoinitiator(en) a) und Aktivator b) im oben angegebenen Verhältnis zueinander beträgt im allgemeinen 1 bis 25 und insbesondere 2 bis 20 Gew.%, bezogen auf das Gewicht der Überzugs- und Aufzeichnungsmaterialien insgesamt, d.h. die Summe der Mengen aller Komponenten derselben. Die verwendete Menge an Photoinitiator hängt von seinem Extinktionskoeffizienten und der Schichtdicke der Materialien bei der Härtung ab und beträgt im allgemeinen 0,5 bis 10 Gew.%, insbesondere etwa 1 bis 5 Gew.% der Gesamtmenge an Überzugs- und Aufzeichnungsmaterial. Die Menge an Aktivator b) soll mindestens 0,5 Gew.% der Gesamtmasse betragen und beträgt insbesondere etwa 1 bis 12 Gew.% der Gesamtmasse und wird von den gewünschten Härtungseigenschaften der Materialschicht beeinflusst. In vielen Fällen hat es sich bei gleicher Photoinitiator-Aktivator-Kombination beim Übergang zu dickeren Materialschichten als vorteilhaft erwiesen, in den dickeren Schichten zur Vermeidung starker Absorption von UV-Strahlung eine geringere Konzentration an Photoinitiator, jedoch eine gleichbleibende Aktivatorkonzentration anzuwenden.

Neben den photopolymerisierbaren Verbindungen, den polymeren Bindemitteln, Photoinitiatoren und Aktivatoren können die Überzugs- und Aufzeichnungsmaterialien noch die üblichen Zusatzstoffe in üblichen Mengen enthalten, wie anorganische oder organische Pigmente oder Farbstoffe, anorganische oder organische Füllstoffe, Polymerisationsinhibitoren, wie Hydrochinon oder tert.-Butylhydrochinon, hautverhindernde Stoffe, wie Paraffin, Verlaufshilfsmittel, wie Silikonöl, Mattierungs- oder Gleitmittel, wie Wachse, organische Lösungsmittel, wie Alkohole, Kohlenwasserstoffe oder Ketone.

Als Farbstoffe enthalten die erfindungsgemässen Überzugs- und Aufzeichnungsmaterialien bevorzugt in einer Menge von im allgemeinen 0,5 bis 2 Gew.% einen Indikatorfarbstoff, der bei Säurezugabe seine Farbe ändert, wie 3′-Phenyl-7-diäthylamino-2,2′-spirodi-(2H-1-benzopyron), Bromkresolgrün oder Methylorange. Sehr geeignet sind Farbstoffe ohne solche Aminogruppierungen, die mit Säuren unter Farbvertiefung Ammoniumsalze bilden.

Zum Auslösen der Photopolymerisation dient Licht einer Wellenlänge von 2300 bis 4500 Å, insbesondere solches mit Emissionsmaxima zwischen 3000 und 4200 Å. Als Strahlungsquellen sind Quecksilberhochdrucklampen, superaktinische Leuchtstoffröhren, Xenon-Impulslampen, Metalljodid-dotierte Lampen und Kohlebogenlampen geeignet.

Die erfindungsgemässen Materialien können in an sich bekannter Art zu Überzügen, UV-härtenden Druckfarben und Druckpasten, Photopolymerdruckplatten, Photoresists, Photolacküberträgungsfolien und photopolymeren silberfreien photographischen Filmen verarbeitet werden.

Es war überraschend, dass die erfindungsgemäss in den Massen enthaltenen spezifischen Dichlormethylgruppen enthaltenden Benzolverbindungen b) einen so stark aktivierenden Effekt ausüben, gleichzeitig eine sehr gute Verträglichkeit mit vielen Bindemitteln und Monomeren zeigen und in erstaunlich hohem Mass chemisch inert sind, vergleicht man sie z.B. mit dem strukturell ähnlichen Benzalchlorid. Durch Zugabe von Silbernitrat zu einer Lösung der Dichlormethylgruppen enthaltenden Benzolverbindungen b) in Methanol unter Wasserzusatz erfolgt kein Silberchlorid-Niederschlag. Da die Aktivatoren b) kaum eine Lichtabsorption oberhalb von 310 nm zeigen, stören sie auch nicht die Absorption von Photoinitiatoren oder Farbstoffen.

Die in den folgenden Beispielen und Vergleichsbeispielen genannten Teile und Prozente beziehen sich, soweit nicht anders angegeben, auf das Gewicht. Teile verhalten sich zu Volumenteilen wie Kilogramm zu Liter.

Vergleichsversuch 1

Man löst 100 Teile eines alkohollöslichen Mischpolyamids, das durch Mischpolykondensation von Adipinsäure, Hexamethylendiamin, 4,4'-Diaminodicyclohexalmethan und ε-Caprolactam hergestellt wurde, sowie 15 Teile m-Xylylenbisacrylamid, 10 Teile Triäthylenglykoldiacrylat, 28 Teile Bis-Glycoläther des N-Methylolacrylamids, 17 Teile N-Methylolmethacrylmethyläther, 1 Teil Benzoinmethyläther und 0,1 Teile Cer-(III)-Salz des N-Nitrosocyclohexylhydroxylamins in 300 Teilen Methanol bei 60°C. Die viskose Lösung wird auf einem Walzwerk bei Temperaturen zwischen 60°-80°C trockengewalzt. Das Walzfell wird zerkleinert und in einer Presse bei 170°C unter einem Druck von 200 kg/cm² zu einer transparenten, farblosen Platte von 0,8 mm Dicke gepresst. Die Platte wird mit einer doppelseitig klebenden Klebefolie auf eine Aluminiumplatte aufgeklebt. Die so hergestellte photopolymere Buchdruckplatte wird durch ein reprographisches Testnegativ (48 Linien/cm) in einem handelsüblichen Druckplatten-Belichtungsgerät, bestückt mit 8 Niederdruckfluorenzröhren à 20 W, unterschiedliche Zeiten belichtet. Nach 24-stündiger Lagerung werden die unbelichteten Teile der Druckplatte mit einem Propanol-Äthanol-Wasser-Gemisch (7:2:1) in einer Auswaschapparatur, die aus einer Pumpe und einer Anzahl von Sprühdüsen besteht und das Lösungsmittel mit einem Druck von 3 atm. auf die auszuwaschende Platte sprüht, ausgewaschen. Nach 10 Min. unterbricht man den Auswaschvorgang, spült die Platte mit frischem Propanol ab und entfernt das anhaftende Lösungsmittel mit Pressluft. Tabelle 1 zeigt die notwendigen Belichtungszeiten zur vollständigen Ausbildung eines 3% Rastertonwertes im Relief.

Beispiel 1

Es wird wie in Vergleichsversuch 1 verfahren, jedoch werden der viskosen Lösung für die Buchdruckplattenherstellung noch 5 Teile 1,4-Bis(dichlormethyl)-benzol zugemischt. Die Ergebnisse der Belichtungsversuche entsprechend Vergleichsversuch 1 gibt Tabelle 1 wieder.

Tabelle 1:

Ausbildung eines 3%-Rastertonwertes in Abhängigkeit von der Belichtungszeit

− = unzureichend
+ = befriedigend
++ = gut

| Druckplatte | Belichtungszeit (min) 2 | 3 | 4 | 6 | 8 |
|---|---|---|---|---|---|
| Vergleichsversuch 1 | − | − | + | + | ++ |
| Beispiel 1 | − | + | ++ | ++ | ++ |

Vergleichsversuch 2

Eine Lösung von 60 Teilen eines Copolymerisats aus 70% Methylmethacrylat, 5% 2-Äthylhexylacrylat, 5% Styrol und 20% Methacrylsäure (hergestellt durch Lösungspolymerisation in Essigester mit Azoisobutyronitril als Polymerisationsstarter), 25 Teilen Pentaerythrit-tetraacrylat, 5 Teilen Hexandiol-1,6-dimethacrylat, 2 Teilen Michlers Keton, 2,5 Teilen Benzophenon, 0,2 Teilen Hydrochinonmonomethyläther und 0,5 Teilen Dispersblau 148 (disperse blue 148) in 300 Teilen Essigester wird in zwei gleiche Teile (A, B) aufgeteilt. Teil A der Lösung wird auf handelsübliche, anodisch angerauhte Aluminiumbleche durch Tauchen so aufgetragen, dass nach dem Trocknen eine Schicht von 0,006 mm verbleibt. Anschliessend wird ebenfalls durch Tauchen eine 6 µm starke Polyvinylalkoholschicht aus wässriger Lösung aufgebracht und getrocknet. Die so erhaltene Offsetdruckplatte wird mit einem reprographischen 14-Stufen-Graukeil vollflächig belichtet, der Stufenkeil hatte eine minimale optische Dichte von 0,4 bei 370 nm, jede weitere Stufe verringerte die optische Dichte um 20% der vorherigen Stufe. Die Druckplatte zeigt nach einer ausreichenden Belichtungsdauer von 65 sec., wobei sich der Photolack von dunkelblau nach hellblau verfärbt hat, und nach einer Entwicklung mit einer Phosphatpufferlösung mit einem pH-Wert von 10 gute Druckeigenschaften in einer Kleinoffsetmaschine.

Es wird ferner die Ausbildung der Stufen bei bestimmten Belichtungszeiten zwischen 1 min und 10 min beurteilt.

Beispiel 2

In Teil B der in Vergleichsversuch 2 angegebenen Lösung werden 2,5 Teile 2,5-Dichlor-1,4-bis(dichlormethyl)-benzol aufgelöst. Die weitere Verarbeitung und Untersuchung erfolgt wie in Vergleichsversuch 2. Die mit einer Belichtungsdauer von 50 sec. bestrahlten und entwickelten Platten zeigen gleich gute Druckeigenschaften wie die des Vergleichsversuchs 2 (mit einer Belichtungsdauer von 65 sec). Die Beurteilung der Ausbildung der Stufen bei Belichtungszeiten zwischen 1 min und 10 min im Vergleich zu den entsprechenden Versuchen von Vergleichsversuch 2 ergibt, dass bei gleichen Belichtungszeiten in den Platten gemäss Beispiel 2 jeweils 2 bis 3 Stufen mehr ausgebildet sind als in den Platten gemäss Vergleichsversuch 2.

Beispiel 3 und 4

54 Teile eines Copolymerisats aus 97% Methylmethacrylat und 3% Acrylamid (hergestellt durch Polymerisation in Essigester mit Benzoylperoxid als Starter, K-Wert nach Fikentscher (Cellulosechemie 13 [1932] 60) von 24, gemessen als 1%ige Lösung in Essigester), 38,5 Teile 1,1,1-Trimethylolpropan-triacrylat, 1,5 Teile Divinyläthylenharnstoff, 2,5 Teile Benzophenon, 0,025 Teilen N-Nitrosodiphenylamin, 0,011 Teile Kristallviolett, 0,3 Teile 3′-Phenyl-7-diäthylamino-2,2′-spirodi-(2H-1-benzopyron), 3,5 Teile eines Polyesters aus Adipinsäure und 1,2-Propylenglykol mit einer Viskosität von 7 Pa. sec. (bei 20°C), 0,3 Teile eines handelsüblichen Silikonöls und 1,5 Teile 1,4-Bis(dichlormethyl)-benzol werden in 140 Teilen Essigester gelöst. Die Lösung wird durch ein Druckfilter mit 1 µm Porendurchmesser filtriert und auf eine 0,023 mm dicke Polyesterfolie in solcher Menge schichtförmig gegossen, dass nach dem Trocknen unter Warmluft ein Photolack von 0,048 mm verbleibt. Der Photolackfilm wird mit einer 30 µm dicken Folie aus Niederdruckpolyäthylen bedeckt. Die dreischichtige Folie wird auf eine Breite von 50 cm geschnitten, auf einen Pappkern aufgewickelt und als Rolle im Dunkeln gelagert. Vor der Verwendung als trokken-laminierbarer Photolack wird in einem handelsüblichen Laminator der Polyäthylendeckfilm abgeschält und der Lack auf vorgebürstete, kupferplattinierte Epoxidharz-Glasfaserplatten bei 110°C mit einer Geschwindigkeit von 1 m/min aufkaschiert. Die Platten werden rundbeschnitten und wie folgt weiterverarbeitet:

Beispiel 3

Eine Platte wird mit UV-Licht durch eine photographische Negativvorlage eines elektrischen Schaltbildes 1 Minute lang belichtet, Danach sind die belichteten Bildteile von blauviolett nach dunkelblau verfärbt und ergeben einen ausgezeichneten Kontrast. Die Polyesterfolie wird daraufhin abgezogen und die unbelichteten Bildteile werden mit 1,1,1-Trichloräthan abgewaschen. Anschliessend wird mit einer Eisen-III-chloridlösung von 44° Baumé geätzt, mit Wasser gespült und getrocknet. Durch 1-minütiges Spülen der Platte mit Aceton wird der belichtete Photolack abgewaschen; man erhält eine elektrische Leiterplatte.

Beispiel 4

Eine Platte wird mit UV-Licht durch eine Positivvorlage eines elektrischen Schaltbildes 1 Minute lang belichtet. Danach werden die Polyesterfolie abgezogen, die unbelichteten Bildteile ausgewaschen und auf die freigelegte Kupferoberfläche galvanisch nacheinander 0,035 mm Kupfer, 0,005 mm Nickel und 0,002 mm Gold abgeschieden. Anschliessend wird durch Spülen mit Methylenchlorid der restliche Photolack abgewaschen und zuletzt mit einer ammoniakalischen Kupfernitratlösung das freistehende Kupfer geätzt. Es wird eine Leiterplatte erhalten, die eine ausgezeichnete Kantenschärfe der Leiterbahnen aufweist.

Vergleichsversuche 3 und 4

Es wird wie in den Beispielen 3 und 4 eine Photolackfolie hergestellt, jedoch wird bei der Herstellung der Lacklösung der Zusatz von 1,4-Bis(dichlormethyl)-benzol weggelassen. Will man mit den Beispielen 3 und 4 vergleichbare Ergebnisse erhalten, muss die erforderliche Belichtungszeit von 1 Minute auf 1 Minute 35 Sekunden erhöht werden. Weiterhin ist nach der Belichtung keine Farbänderung nach dunkelblau zu beobachten.

Beispiele 5 und 6 sowie Vergleichsversuche 5 bis 10

Es werden jeweils Lösungen hergestellt aus 53 Teilen des in Beispiel 3 angegebenen Copolymerisats, 20 Teilen Trimethylolpropantriacrylat, 10 Teilen eines Umsetzungsproduktes aus 1,4-Butandioldiglycidester mit einer äquivalenten Menge Acrylsäure, 6 Teilen Triäthylenglykoldiacrylat, 0,5 Teilen Divinylpropylenharnstoffe, 2,5 Teilen Benzophenon, 0,4 Teilen Michlers Keton, 0,05 Teilen 2,6-Di-tert.-butyl-4-methylphenol, 3,5 Teilen Tribenzylphosphat und 0,3 Teilen 3′-Phenyl-7-diäthylamino-2,2′-spirodi-(2H-1-benzopyron) in 200 Teilen Essigester.

Zu je gleichen Lösungsansätzen dieser Art werden die in Tabelle 2 angegebenen Chlorverbindungen in den dort angegebenen Mengen zugemischt. Die 25 so hergestellten unterschiedlichen Lösungen werden wie in den Beispielen 3/4 angegeben, zu Photolackfolien verarbeitet, die dann auf kupferplattierte Epoxidharz-Glasfaserplatten laminiert und bildmässig mit UV-Licht durch ein photographisches Negativ eines Schaltungsmotives mit 0,1 mm breiten Leitungsbahnen belichtet werden. Dabei beträgt die Belichtungszeit jeweils nur 45 sec. anstatt der für die Verarbeitung an sich notwendigen Zeit von 1 min. Nach einstündiger Lagerung und Abziehen der Polyesterfolie wird mit 1,1,1-Trichloräthan entwickelt, wobei ein mechanisch angetriebener Plüschtampon ständig kreisend über das Schaltungsbild bewegt wird. Die notwendige Mindestentwicklungszeit beträgt in allen Fällen 10 bis 15 sec.

Es wird bei allen Proben die maximal zulässige Auswaschbarkeit bestimmt, nach der sich auch die belichteten Bildteile von der Kupferoberfläche lösen. Die Ergebnisse zeigt Tabelle 2. Sie zeigen besonders deutlich die Wirkung der erfindungsgemässen Verbindungen auf die Photopolymerisation. Bei einer Belichtungszeit von 1 min fallen die Unterschiede geringer aus; jedoch ist selbst bei zehnfacher Überbelichtung (600 sec) der Effekt noch gut messbar.

Tabelle 2: Maximal zulässige Auswaschzeit (min) bei Zusatz verschiedener Chlorverbindungen in unterschiedlichen Mengen

| | Chlorverbindung | 0 Teile | 0,5 Teile | 1 Teil | 3 Teile |
|---|---|---|---|---|---|
| Beispiel 5 | 1,4-Bis(dichlormethyl)-benzol | 6,5 | 17 | 26 | 50 |
| Beispiel 6 | 2,5-Dichlor-1,4-bis(dichlormethyl)-benzol | 6,5 | 18 | 26 | 52 |
| Vgl. Versuch 5 | Chlorparaffin techn. (70% Cl) | 6,5 | 6,5 | 8 | 12 |
| Vgl. Versuch 6 | Chloriertes Biphenyl | 6,5 | 7 | 7 | 12 |
| Vgl. Versuch 7 | Hexachlorcyclohexan (Isomerengemisch) | 6,5 | 7 | 8 | 13 |
| Vgl. Versuch 8 | p-Dichlormethylbenzophenon (kein Zusatz von Benzophenon) | – | 2 | 5 | 8 |
| Vgl. Versuch 9 | Hexandiol-1,6-bis(trichloracetat) | 6,5 | 10 | 13 | 30 |
| Vgl. Versuch 10 | 1,4-Bis(trichlormethyl)-benzol | 6,5 | 10 | 12 | 31 |

Beispiel 7

Es wird ein lichthärtendes Druckfarbenbindemittel hergestellt aus 49 Teilen des Umsetzungsproduktes aus 1 Mol Hexamethylendiisocyanat und 2 Molen Hydroxypropylacrylat, 20 Teilen des Umsetzungsproduktes aus 1 Mol Toluylendiisocyanat und 2 Molen Hydroxypropylacrylat, 8 Teilen Pentaerythrit-tetraacrylat, 3 Teilen p,p-Bis-(diäthylamino)-benzophenon, 3 Teilen p-Dimethylaminobenzaldehyd, 4 Teilen Benzophenon, 3 Teilen 4-Phenylamino-azobenzol und 10 Teilen 2,5-Dichlor-1,4-bis(dichlormethyl)-benzol.

In einer modifizierten Buchdruckmaschine wird mit diesem Bindemittel jeweils 5 mal auf kupferplattierte Epoxidharzplatten gedruckt, wobei zwischen jedem Druckvorgang durch 0,6 sec Belichtung mit einer 1000 Watt Quecksilberhochdrucklampe die einzelnen Farbschichten von jeweils 1,5 µm Dicke getrocknet werden. Als Druckplatte wird eine handelsübliche photopolymere Hochdruckplatte auf Polyamid-Basis verwendet, als Motiv wird das Bild einer elektrischen Schaltung gedruckt. Nachdem auf die Platte 7,5 µm Druckfarbe aufgetragen sind, wird ½ Stunde getrocknet und anschliessend die freiliegende Kupferoberfläche mit einer wässrigen Eisen-III-chloridlösung von 44° Baumé geätzt. Die erhaltenen Leiterplatten zeigen nach einer Auflage von 1000 Stück eine ausgezeichnete Kantenschärfe auch feinster Konturen sowie sehr gute Masshaltigkeit. Die Abweichungen vom Original waren nicht höher als 2 µm, während bei Leiterplatten, die im Siebdruck hergestellt werden, üblicherweise Abweichungen bis zu 25 µm im Auflagendruck gemessen werden.

Vergleichsversuch 11

Es wird ein Buchdruckmittel wie in Beispiel 7 hergestellt, jedoch enthält es anstelle des 2,5-Dichlor-1,4-bis(dichlormethyl)-benzol eine gleiche Menge an 1,4-Bis(trichlormethyl)-benzol. Es kann ebenfalls zum Drucken von Schaltungen im Hochdruck eingesetzt werden. Allerdings musste jeweils 1,1 Sekunden je Druck belichtet werden.

Beispiel 8

Die Lösung gemäss Beispiel 2 wird als Überzug auf ein gewebtes, maschenartiges Substrat in 20 µm starker Schicht aufgebracht. Nach dem bildmässigen Belichten mit aktinischem Licht und Entwickeln in wässrig-alkalischer Lösung dient der photopolymerisierte Bildbereich als ausgezeichnete Maske für den Siebdruck.

**Patentansprüche**

1. Photopolymerisierbare Überzugs- und Aufzeichnungsmaterialien mit mindestens einer photopolymerisierbaren olefinisch ungesättigten organischen Verbindung, die als aktiviertes Photoinitiatorsystem
a) mindestens eine bei Belichtung mit aktinischem Licht polymerisationsauslösende Radikale bildende aromatische Carbonylverbindung und
b) meinen halogenierten Kohlenwasserstoff enthalten,
dadurch gekennzeichnet, dass sie als halogenierten Kohlenwasserstoff b) eine mindestens zwei an den Benzolkern gebundene Dichlormethylgruppen aufweisende Benzolverbindung enthalten.

2. Photopolymerisierbare Überzugs- und Aufzeichnungsmaterialien nach Anspruch 1, dadurch gekennzeichnet, dass sie als halogenierten Kohlenwasserstoff b) ein Bis(dichlormethyl)-benzol enthalten.

3. Photopolymerisierbare Überzugs- und Aufzeichnungsmaterialien nach Anspruch 1, dadurch gekennzeichnet, dass sie als halogenierten Kohlenwasserstoff b) 2,5-Dichlor-1,4-bis(dichlormethyl)-benzol enthalten.

4. Photopolymerisierbare Überzugs- und Aufzeichnungsmaterialien gemäss einem der Ansprüche 1 bis 3, dadurch gekennzeichnet, dass ihr Gehalt an Dichlormethylgruppen aufweisender Benzolverbindung b) mindestens 0,5 Gew.%, bezogen auf die Gesamtmasse, beträgt und sie 0,2 bis 12 Gewichtsteile der genannten Verbindung pro Gewichtsteil an aromatischer Carbonylverbindung a) enthalten.

5. Photopolymerisierbare Überzugs- und Aufzeichnungsmaterialien gemäss einem der Ansprüche 1 bis 4, dadurch gekennzeichnet, dass sie als aromatische Carbonylverbindung a) Benzophenon oder ein Substituenten tragendes Benzophenon enthalten.

6. Photopolymerisierbare Überzugs- und Aufzeichnungsmaterialien gemäss einem der Ansprüche 1 bis 5, dadurch gekennzeichnet, dass sie einen Indikatorfarbstoff erhalten, der bei Säurezugabe seine Farbe ändert.

7. Photolacküberträgungsfolien und Photoresistmaterialien, enthaltend ein photopolymerisierbares Überzugs- und Aufzeichnungsmaterial gemäss einem der Ansprüche 1 bis 6.

**Claims**

1. A photopolymerizable coating and recording material comprising at least one photopolymerizable olefinically unsaturated organic compound and containing, as activated photoinitiator system,
a) at least one aromatic carbonyl compound that, when exposed to actinic light, forms free radicals which initiate polymerization, and
b) a halogenated hydrocarbon
wherein a benzene compound having at least two dichloromethyl groups bound to the benzene nucleus is contained as halogenaimed in claim 1, wherein 2,5-dichloro-1,4-bis(dichloromethyl)-benzene is contained as halogenated hydrocarbon b).

4. A photopolymerizable coating and recording material as claimed in any of claims 1 to 3, wherein the amount of benzene compound b) containing dichloromethyl groups is at least 0,5% by weight of the whole composition, and from 0.2 to 12 parts by weight of the said compound is present per part by weight of aromatic carbonyl compound a).

5. A photopolymerizable coating and recording material as claimed in any of claims 1 to 4, wherein benzophenone or a substituted benzophenone is present as aromatic carbonyl) compound a).

6. A photopolymerizable coating and recording material as claimed in any of claims 1 to 4, wherein a dye which changes color on addition of acid is additionally present.

7. Photopolymer dry film resist materials and photoresist materials containing a photopolymerizable coating and recording material as claimed in any of claims 1 to 7.

**Revendications**

1. Matériaux de revêtement et d'enregistrement photopolymérisables comprenant au moins un composé organique à insaturation oléfinique photopolymérisable, qui contiennent en tant que système photo-initiateur activé,
a) au moins un composé carbonyle aromatique formant des radicaux amorceurs de polymérisation sous l'effet d'une exposition à une lumière actinique, et
b) un hydrocarbure halogéné,
caractérisés par le fait qu'ils contiennent en tant qu'hydrocarbure halogéné b) un composé benzénique comportant au moins deux groupes dichlorométhyle fixés au noyau benzène.

2. Matériaux de revêtement et d'enregistrement photopolymérisables selon la revendication 1, caractérisés par le fait qu'ils contiennent en tant qu'hydrocarbure halogéné b) un bis (dichlorométhyl)-benzène.

3. Matériaux de revêtement et d'enregistrement photopolymérisables selon la revendication 1, caractérisés par le fait qu'ils contiennent en tant qu'hydrocarbure halogéné b) du 2,5-dichloro-1,4-bis(dichlorométhyl)-benzène.

4. Matériaux de revêtement et d'enregistrement photopolymérisables selon l'une des revendications 1 à 3, caractérisés par le fait que leur teneur en composé benzénique b) comportant des groupes dichlorométhyle est d'au moins 0,5%, rapportée à la masse totale, et qu'ils contiennent de 0,2 à 12 parties en poids du composé précité par partie en poids du composé carbonyle aromatique a).

5. Matériaux de revêtement et d'enregistrement photopolymérisables selon l'une des revendications 1 à 4, caractérisés par le fait qu'ils contiennent en tant que composé carbonyle aromatique a) de la benzophénone ou de la benzophénone portant un substituant.

6. Matériaux de revêtement et d'enregistrement photopolymérisables selon l'une des revendications 1 à 5, caractérisés par le fait qu'ils contiennent un indicateur coloré dont la couleur change en cas d'addition d'acide.

7. Feuilles de transfert de vernis photosensible et photoresists contenant un matériau de revêtement et d'enregistrement selon l'une des revendications 1 à 6.